(19) Europäisches Patentamt
European Patent Office
Office européen des brevets

(11) EP 0 719 825 B1

(12) EUROPÄISCHE PATENTSCHRIFT

(45) Veröffentlichungstag und Bekanntmachung des Hinweises auf die Patenterteilung:
**08.09.1999 Patentblatt 1999/36**

(51) Int Cl.[6]: **C08K 5/13**, C08G 59/14

(21) Anmeldenummer: **95119968.6**

(22) Anmeldetag: **18.12.1995**

# (54) Stabilisierte, Phosphormodifizierte Epoxidharze und ihre Verwendung

Phosphorus-modified stabilized epoxy resins and their use

Résines époxydes stabilisées modifiées par du phosphore et leur utilisation

(84) Benannte Vertragsstaaten:
**BE CH DE FR GB IT LI NL**

(30) Priorität: **30.12.1994 DE 4447277**

(43) Veröffentlichungstag der Anmeldung:
**03.07.1996 Patentblatt 1996/27**

(73) Patentinhaber: **HOECHST AKTIENGESELLSCHAFT**
**65929 Frankfurt am Main (DE)**

(72) Erfinder:
- **Kleiner, Hans-Jerg, Dr.**
  **D-61476 Kronberg (DE)**
- **Regnat, Dieter, Dr.**
  **D-65817 Eppstein (DE)**

(56) Entgegenhaltungen:
**WO-A-94/21704** **DE-A- 2 331 718**

- **DATABASE WPI Week 9443 Derwent Publications Ltd., London, GB; AN 94-347183 XP002030158 & JP 06 271 648 A (HITACHI CHEM. CO. LTD.) , 27.September 1994**

EP 0 719 825 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Phosphorhaltige Epoxidharze sind für die Herstellung von flammwidrigen Reaktionsharzformstoffen und Beschichtungen mit hohem thermischen, mechanischen und elektrischen Eigenschaftsniveau sowie zur Herstellung von Laminaten von Bedeutung (vgl. PCT-Patenanmeldung WO 94/21704). Sie zeichnen sich neben ihrer Flammwidrigkeit vor allem durch ein sehr verarbeitungsfreundliches Verhalten aus, da sie unter anderem eine gute Lagerstabilität aufweisen. Die Lagerstabilität ist gleichwohl verbesserungswürdig, da sie insbesondere bei höheren Temperaturen nicht immer voll befriedigt.

Die vorliegende Erfindung betrifft nun phosphormodifizierte Epoxidharze mit verbesserter Lagerstabilität, insbesondere bei höheren Temperaturen, die einen Epoxidwert von 0 bis etwa 1 mol/100 g aufweisen und die Struktureinheiten enthalten, die sich ableiten

(A) von Polyepoxidverbindungen mit mindestens zwei Epoxidgruppen, vorzugsweise endständigen Epoxidgruppen, pro Molekül und
(B) von Phosphin- und/oder Phosphonsäureanhydriden,

dadurch gekennzeichnet, daß ihnen mindestens ein phenolisches Antioxidans beigemischt ist.

Die erfindungsgemäß eingesetzten phosphormodifizierten Epoxidharze, die also Addukte aus Verbindungen gemäß (A) und gemäß (B) sind, weisen je nach Epoxidharz im allgemeinen einen Phosphorgehalt von etwa 0,5 bis 13 Gew.-%, bezogen auf das Harz, auf. Dieser Phosphorgehalt läßt sich durch das Molverhältnis von Polyepoxidverbindung zu Phosphinsäureanhydrid/Phosphonsäureanhydrid je nach Bedarf einstellen. Durch die Funktionalität des verwendeten Epoxidharzes läßt sich weiterhin die Forderung realisieren, wonach im Mittel vorzugsweise mindestens eine Epoxidgruppe pro Molekül des phosphormodifizierten Epoxidharzes enthalten sein soll.

Vorzugsweise besitzen die erfindungsgemäß eingesetzten phosphormodifizierten Epoxidharze einen Phosphorgehalt von etwa 1 bis 8 Gew.-%, insbesondere etwa 2 bis 5 Gew.-%, %, bezogen auf das Harz. Sie sind vorzugsweise härtbar. Im Mittel enthalten sie vorzugsweise mindestens eine Epoxidgruppe, insbesondere 1 bis 3 Epoxidgruppen pro Molekül; die mittlere Funktionalität beträgt dementsprechend vorzugsweise mindestens 1, insbesondere 1 bis 3. Der Epoxidwert liegt vorzugsweise bei etwa 0,02 bis 1 mol/100 g, besonders bevorzugt bei etwa 0,02 bis 0,6 mol/100 g. Weiterhin weisen die erfindungsgemäßen phosphormodifizierten Epoxidharze im allgemeinen ein mittleres Molekulargewicht $\overline{M}_n$ (Zahlenmittel; bestimmt mittels Gelchromatographie; Polystyrolstandard) von bis zu etwa 10000, vorzugsweise von etwa 200 bis 5000 und insbesondere von etwa 400 bis 2000 auf.

Die erfindungsgemäß eingesetzten phosphormodifizierten Epoxidharze sind praktisch unvernetzt. Der Gelanteil in ihnen überschreitet im allgemeinen nicht 5 Gew.-% und ist vorzugsweise kleiner als 1 Gew.-%.

Das mittlere Molekulargewicht $\overline{M}_n$ (Zahlenmittel; gleichfalls bestimmt mittels Gelchromatographie; Polystyrolstandard) der Bausteine (A) beträgt im allgemeinen bis zu etwa 9000 und liegt vorzugsweise zwischen etwa 150 und 4000, insbesondere zwischen etwa 300 und 1800; sie leiten sich vorzugsweise von Polyepoxidverbindungen mit im Mittel 2 bis 6 Epoxidgruppen pro Molekül (einer Funktionalität von 2 bis 6) ab. Vorzugsweise handelt es sich dabei bei diesen Polyepoxidverbindungen um Polyglycidylether auf Basis von aromatischen Aminen, mehrwertigen Phenolen, Hydrierungsprodukten dieser Phenole und/oder von Novolaken (siehe hierzu nachfolgend).

Die Struktureinheiten (B) leiten sich vorzugsweise von Phosphinsäureanhydriden der Formeln (I) und/oder (II) ab

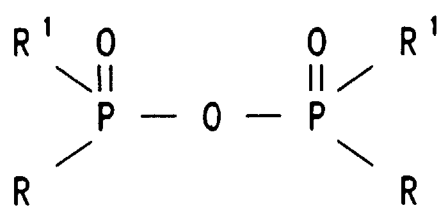

(I)

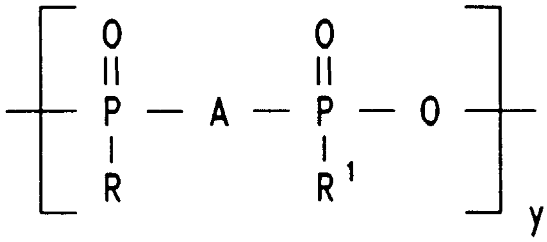

(II)

in denen bedeuten

R und $R^1$ unabhängig voneinander einen Kohlenwasserstoffrest von 1 bis 20 C-Atomen, vorzugsweise 1 bis 10 C-Atomen, der aliphatischen und/oder aromatischen Charakter haben und durch Heteroatome oder Heteroatomgruppen unterbrochen sein kann, vorzugsweise einen gesättigten oder ungesättigten, geradkettigen oder verzweigten aliphatischen Rest, wie Alkyl, Alkenyl, Cycloalkyl, mit vorzugsweise 1 bis 8 C-Atomen, insbesondere 1 bis 6 C-Atomen, wie Methyl, Ethyl, n- und i-Propyl, n-, i- und tert.-Butyl, die verschiedenen Pentyle und Hexyle, oder einen Aryl- oder einen Aralkylrest, wie unsubstituiertes oder mit vorzugsweise 1 bis 3 Alkylresten mit 1 bis 6 C-Atomen substituiertes Phenyl oder Naphthyl oder wie Phenylalkyl mit 1 bis 6 C-Atomen im Alkylrest, beispielsweise Benzyl;

A einen zweiwertigen Kohlenwasserstoffrest mit 1 bis 10 C-Atomen, vorzugsweise 1 bis 6 C-Atomen und insbesondere 1 bis 4 C-Atomen, der aliphatischen und/oder aromatischen Charakter haben und durch Heteroatome oder Heteroatomgruppen unterbrochen sein kann, vorzugsweise einen zweiwertigen gesättigten oder ungesättigten, geradkettigen oder verzweigten aliphatischen Rest und insbesondere ein Alkylenrest, wie Methylen, Propylen udgl.,

y eine ganze Zahl von mindestens 1, vorzugsweise 1 bis 100 und insbesondere 1 bis 30, wobei bei y = 1 das Brückenglied A vorzugsweise mindestens 2 C-Atome besitzt.

Bevorzugt leiten sich die Struktureinheiten (B) weiterhin von Phosphonsäureanhydriden der Formel (III) ab

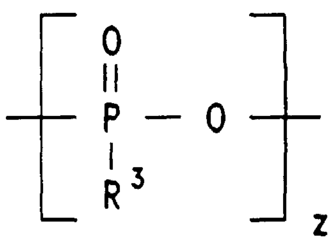

(III)

in der $R^3$ die gleiche Bedeutung wie $R/R^1$ gemäß den Formeln (I) bzw. (II) besitzt und z für mindestens 3, vorzugsweise 3 bis 100 und insbesondere 20 bis 60 steht. Gegebenenfalls können neben diesen Struktureinheiten auch solche vorhanden sein, die sich von Phosphinsäureanhydriden der obigen Formeln (I) und/oder (II) ableiten.

Gemäß einer bevorzugten Ausgestaltungsform besitzt das phosphormodifizierte Epoxidharz der Erfindung im wesentlichen die durch die nachstehenden Formeln (IV), (V) und/oder (VI) ausgedrückte Struktur

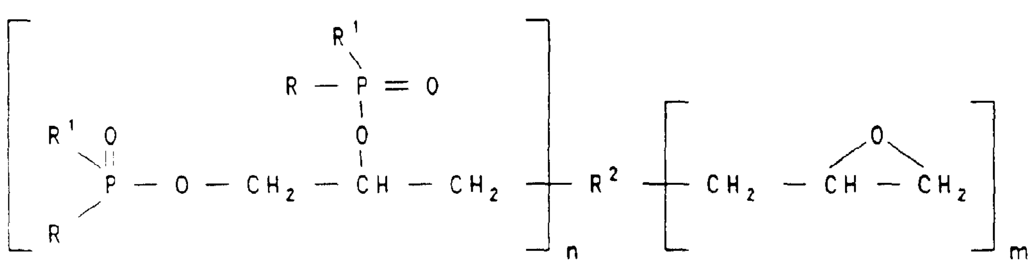

(IV)

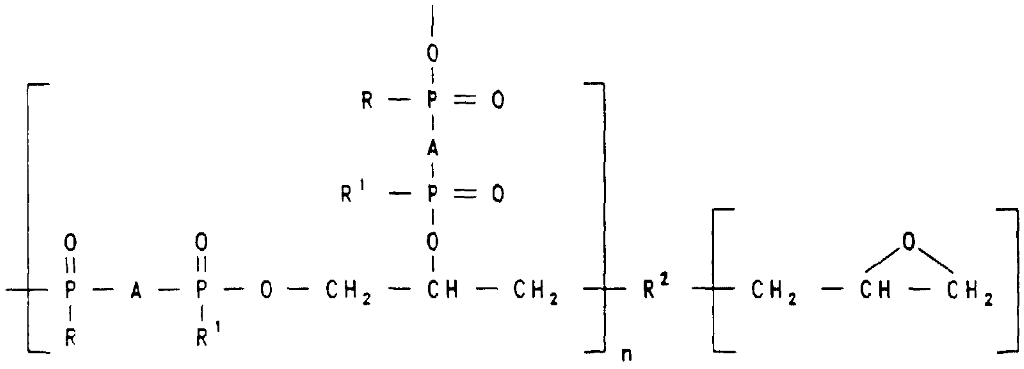

(V)

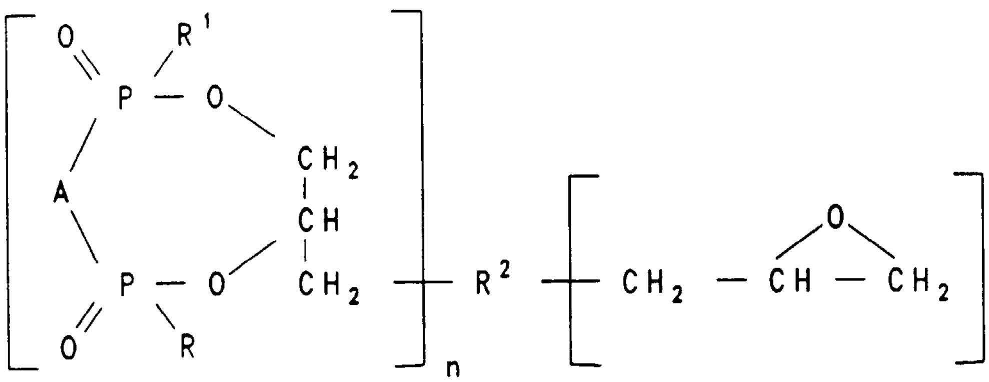

(Va)

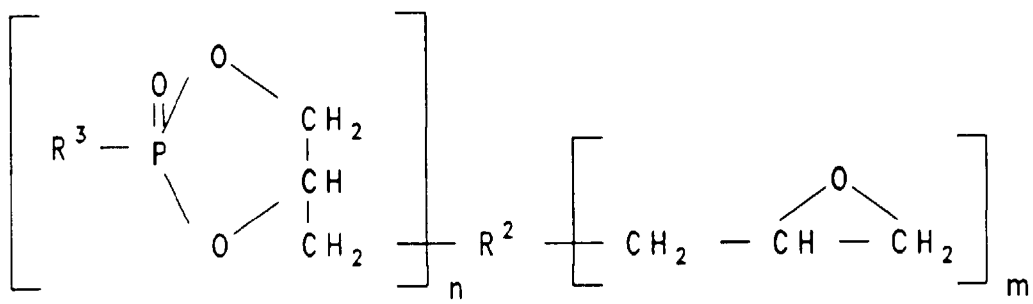

(VI)

in denen bedeuten

R, $R^1$ und $R^3$ gleiche Bedeutung wie unter den obigen Formeln (I) bis (III);
$R^2$ den um die Glycidylgruppen verminderten Rest einer Polyepoxidverbindung;
n = ganze Zahlen von 1 bis 5, vorzugsweise 1 bis 3;
m = ganze Zahlen von 1 bis 5, vorzugsweise 1 bis 3, wobei die Summe n+m eine ganze Zahl von 2 bis 6, vorzugsweise 2 bis 4 sein soll.

Beispielsweise steht $R^2$ für den um die Glycidylgruppen verminderten (n + m)-wertigen Rest

- eines Polyethers, eines Polyetherpolyols, eines Polyesters oder eines Polyesterpolyols;
- eines Kohlenwasserstoffrestes, der gesättigten oder ungesättigten aliphatischen Charakter und/oder aromatische Charakter haben und der durch Heteroatome, wie Sauerstoff und Stickstoff, sowie durch Heteroatomgruppen, wie $-NR^1CO-$ ($R^1$ gleiche Bedeutung wie oben) unterbrochen sein und/oder diese enthalten kann, wobei dieser Kohlenwasserstoffrest, der in der Regel mindestens 6, vorzugsweise mindestens 12 bis 30 C-Atome enthält, vorzugsweise Arylgruppen, insbesondere Phenylgruppen enthält, die substituiert sein können, aber vorzugsweise unsubstituiert sind;

- eines Umsetzungsproduktes einer Epoxy-Verbindung mit Polyaminen, Polyolen, Polycaprolactonpolyolen, OH-gruppenhaltigen Polyestern, Polyethern, Polyglykolen, hydroxy-, carboxyl- und aminofunktionellen Polymerölen, Polycarbonsäuren, hydroxy- oder aminofunktionellen Polytetrahydrofuranen.

$R^2$ kann auch für verschiedene dieser Reste stehen.

Bevorzugt bedeutet $R^2$ den entsprechenden Rest eines Bisphenol-A-diglycidylethers, eines Bisphenol-F-diglycidylethers oder von deren Oligomeren, eines Polyglycidylethers von Phenol/Formaldehyd- bzw. Kresol/Formaldehyd-Novolak, eines Diglycidylesters von Tetrahydrophthal-, Phthal-, Isophthal- oder Terephthalsäure sowie Mischungen dieser Reste.

Nachstehend seien einige dieser Reste $R^2$ formelmäßig wiedergegeben:

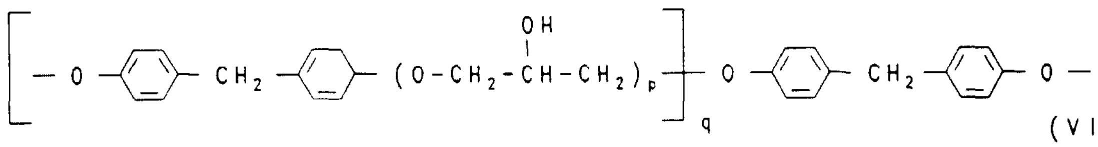

(VIIa)

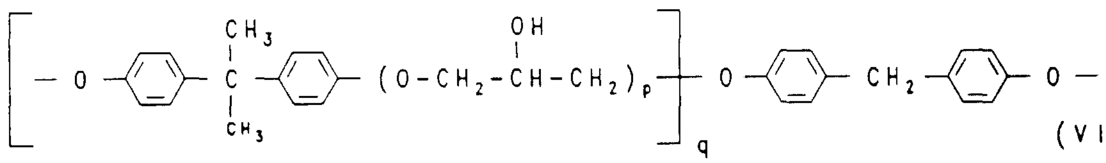

(VIIb)

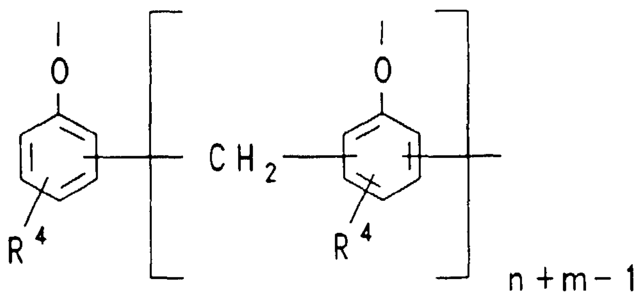

(VIIc)

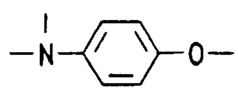

(VIId)

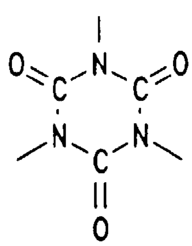

(VIIe)

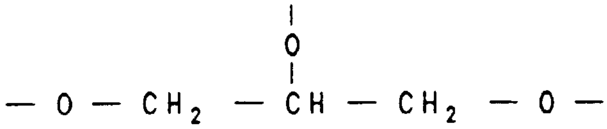

(VIIf)

$$-CH_2-R^5-CH_2-\ (R^5 = (CH_2)_r,\qquad (VIIf)$$

oder Cyclohexylen in denen $R^4$ Wasserstoff und/oder der $C_1$- bis $C_{10}$-Alkyl-Rest ist, und die Indices n und m die Bedeutung gemäß den Formeln (IV) bis (VI) haben, der Index p für 0 oder 1, der Index q für ganze Zahlen von 0 bis 40, vorzugsweise 0 bis 10 und der Index r für ganze Zahlen von 4 bis 8 steht.

Die Herstellung der erfindungsgemäß eingesetzten phosphormodifizierten Epoxidharze kann durch Umsetzung der Polyepoxidverbindungen gemäß (A) mit den Phosphin- und/oder Phosphonsäureanhydriden gemäß (B) erfolgen, vorzugsweise in einem inerten Lösungs(Verdünnungs)mittel oder bei angepaßter Reaktionsführung auch in Substanz, wie in der eingangs erwähnten PCT-Patentanmeldung WO 94/21704 beschrieben, auf die hier Bezug genommen wird. Gemäß einer gleichfalls in dieser Patentanmeldung beschriebenen Variante lassen sich die phosphormodifizierten Epoxidharze, wobei sich hier die Struktureinheiten (B) nur von Phosphonsäureanhydriden ableiten, dadurch herstellen, daß man aus phosphormodifizierten Epoxiden, enthaltend Struktureinheiten, die sich ableiten von Polyepoxidverbindungen mit mindestens zwei Epoxidgruppen pro Molekül und von Phosphonsäurehalbestern, bei Temperaturen von mindestens 80°C Alkohol abspaltet. Bevorzugt erfolgt diese Alkoholabspaltung bei Temperaturen von 80 bis 250°C, insbesondere bei 100 bis 150°C, und bei vermindertem Druck, vorzugsweise 100 bis 0,1 Torr, insbesondere 5 bis 0,5 Torr. Durch Zugabe von Umesterungskatalysatoren kann diese Alkoholabspaltung beschleunigt werden.

Die zur Herstellung der phosphormodifizierten Epoxidharze verwendeten Polyepoxidverbindungen, die vorzugsweise halogenfrei sind, können gesättigt oder ungesättigt sowie aliphatisch, cycloaliphatisch, aromatisch und/oder heterocyclisch sein. Sie können weiterhin solche Substituenten enthalten, die unter den Mischungs- oder Reaktionsbedingungen keine störenden Nebenreaktionen verursachen, beispielsweise Alkyl- oder Arylsubstituenten, Ethergruppierungen oder ähnliche. Es können auch Gemische verschiedener Polyepoxidverbindungen verwendet werden.

Bevorzugt besitzen diese Polyepoxidverbindungen die Formel (VIII)

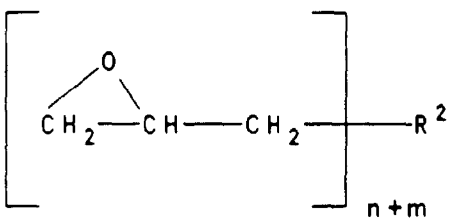

(VIII)

in der $R^2$ sowie die Indices n und m die Bedeutung gemäß den Formeln (IV) bis (VI) haben.

Beispielsweise handelt es sich bei diesen Polyepoxidverbindungen um Polyglycidylether auf Basis von mehrwertigen, vorzugweise zweiwertigen Alkoholen, Phenolen, Hydrierungsprodukten dieser Phenole und/oder von Novolaken (Umsetzungsprodukte von ein- oder mehrwertigen Phenolen, wie Phenol und/oder Kresole, mit Aldehyden, insbesondere Formaldehyd in Gegenwart saurer Katalysatoren), die man in bekannter Weise, beispielsweise durch Umsetzung der jeweiligen Polyole mit Epichlorhydrin, erhält.

Als mehrwertige Phenole sind hier beispielsweise zu nennen: Resorcin, Hydrochinon, 2,2-Bis-(4-hydroxyphenyl)-propan (Bisphenol A), Isomerengemische des Dihydroxydiphenylmethans (Bisphenol F), 4,4'-Dihydroxydiphenylcyclohexan, 4,4'-Dihydroxy-3,3'-dimethyldiphenylpropan, 4,4'-Dihydroxydiphenyl, 4,4'-Dihydroxybenzophenon, Bis-(4-hydroxyphenyl)-1, 1-ethan, Bis-(4-hydroxyphenyl)-1,1'-isobutan, Bis-(4-hydroxy-tert.-butylphenyl)-2,2-propan, Bis-(2-hydroxynaphthyl)-methan, 1,5-Dihydroxynaphthalin, Tris-(4-hydroxyphenyl)-methan, Bis-(4-hydroxyphenyl)-1,1'-ether. Bisphenol A und Bisphenol F sind hierbei bevorzugt.

Auch die Polyglycidylether von mehrwertigen aliphatischen Alkoholen sind als Polyepoxidverbindung geeignet. Als Beispiele derartiger mehrwertiger Alkohole seien 1,4-Butandiol, 1,6-Hexandiol, Polyalkylenglykole, Glycerin, Trimethylolpropan, Bis-(4-hydroxycyclohexyl)-2,2-propan und Pentaerythrit genannt.

Weiter kommen als Polyepoxidverbindungen auch (Poly)glycidylester in Frage, die man erhält durch Umsetzung von Epichlorhydrin oder ähnlichen Epoxyverbindungen mit einer aliphatischen, cycloaliphatischen oder aromatischen Polycarbonsäure, wie Oxalsäure, Adipinsäure, Glutarsäure, Phthal-, Isophthal-, Terephthal-, Tetrahydrophthal- oder Hexahydrophthalsäure, 2,6-Naphthalindicarbonsäure und dimerisierte Fettsäuren. Beispiele hierfür sind Terephthalsäurediglycidylester und Hexahydrophthalsäurediglycidylester.

Auch Polyepoxidverbindungen, die die Epoxidgruppen in statistischer Verteilung über die Molekülkette enthalten und die durch Emulsions-Copolymerisation unter Verwendung von olefinisch ungesättigten, diese Epoxydgruppen enthaltenden Verbindungen hergestellt werden können, wie z.B. Glycidylester der Acryl- bzw. Methacrylsäure, können in manchen Fällen vorteilhaft eingesetzt werden.

Weitere verwendbare Polyepoxidverbindungen sind beispielsweise solche auf der Basis heterocyclischer Ringsysteme, wie z.B. Hydantoinepoxidharze, Triglycidylisocyanurat und/oder dessen Oligomere, Triglycidyl-p-aminophenol, Triglycidyl-p-aminodiphenylether, Tetraglycidyldiaminodiphenylmethan, Tetraglycidyldiaminodiphenylether, Tetrakis(4-glycidoxyphenyl)-ethan, Urazolepoxide, Uracilepoxide, oxazolidinonmodifizierte Epoxidharze. Weiterhin Polyepoxide auf der Basis von aromatischen Aminen, wie Anilin, beispielsweise N,N-Diglycidylanilin, Diaminodiphenylmethan und N,N'-Dimethylaminodiphenylmethan oder -sulfon.

Bevorzugt eingesetzte Polyepoxidverbindungen sind Bisglycidylether auf Basis von Bisphenol A, Bisphenol F und Bisphenol S (Umsetzungsprodukte dieser Bisphenole und Epichlor(halogen)hydrin) oder deren Oligomere, Polyglycidylether von Phenol/Formaldehyd- und/oder Kresol/Formaldehyd-Novolake sowie Diglycidylester der Phthal-, Isophthal-, Terephthal-, Tetrahydrophthal- und/oder Hexahydrophthalsäure.

Die zur Umsetzung mit der Polyepoxidverbindung verwendeten Phosphinsäureanhydride besitzen vorzugsweise die Formeln (I) und/oder (II). Als Vertreter sind hier zu nennen: Dimethylphosphinsäureanhydrid, Ethylmethylphosphinsäureanhydrid, Diethylphosphinsäureanhydrid, Dipropylphosphinsäureanhydrid, Ethylphenylphosphinsäureanhydrid und Diphenylphosphinsäureanhydrid. Beispiele für geeignete Bisphosphinsäureanhydride sind: Ethan-1,2-bismethylphosphinsäureanhydrid, bismethylphosphinsäureanhydrid, Butan-1,4-bismethylphosphinsäureanhydrid, Butan-1,4-bismethylphosphinsäureanhydrid, Hexan-1,6-bismethylphosphinsäureanhydrid und Dekan-1,10-bismethylphosphinsäureanhydrid.

Als Phosphonsäureanhydride, die die Formel (III) aufweisen, kommen beispielsweise in Frage: Methanphosphonsäureanhydrid, Ethanphosphonsäureanhydrid, n- und/oder i-Propanphosphonsäureanhydrid, Hexanphosphonsäureanhydrid, Oktanphosphonsäureanhydrid, Dekanphosphonsäureanhydrid und Benzolphosphonsäureanhydrid.

Bezüglich weiterer Einzelheiten der Herstellung der erfindungsgemäß eingereichten phosphormodifizierten Epoxidharze, einschließlich der Herstellung der Vorstufen, sei auf die erwähnte PCT-Patentanmeldung WO 94/21704 verwiesen.

Als phenolische Antioxidantien können die üblicherweise hierfür bekannten Verbindungen eingesetzt werden. Beispielsweise seien hier genannt:

1. Alkylierte Monophenole, beispielsweise 2,4-Di-t-butylphenol, 2,6-Di-t-butylphenol, 2,6-Di-t-butyl-4-methylphenol, 2-t-Butyl-4,6-dimethylphenol, 2,6-Di-t-butyl-4-ethylphenol, 2,6-Di-t-butyl-4-i-butylphenol, 2,6-Di-cyclopentyl-4-methylphenol, 2-(a-Methylcyclohexyl)-4,6-dimethylphenol, 2,6-Di-octadecyl-4-methylphenol, 2,4,6-Tri-cyclohexylphenol, 2,6-Di-t-butyl-4-methoxymethylphenol;

2. Hydrochinon oder alkylierte Hydrochinone, beispielsweise 4-Methoxyphenol, 2,6-Di-t-butyl-4-methoxyphenol, 2,5-Di-t-butyl-hydrochinon, 2,5-Di-t-amyl-hydrochinon, 2,6-Diphenyl-4-octadecyloxyphenol;

3. Hydroxylierte Thiodiphenylether, beispielsweise 2,2'-Thio-bis-(6-t-butyl-4-methylphenol), 2,2'-Thio-bis-(4-octylphenol), 4,4'-Thio-bis-(6-t-butyl-3-methylphenol), 4,4'-Thio-bis-(6-t-butyl-2-methylphenol);

4. Alkyliden-Bisphenole, beispielsweise 2,2'-Methylen-bis-(6-t-butyl-4-methylphenol), 2,2'-Methylen-bis-(6-t-butyl-4-ethylphenol), 2,2'-Methylen-bis-[4-methyl-6-($\alpha$-methylcyclohexyl)-phenol], 2,2'-Methylen-bis-(4-methyl-6-cyclohexylphenol), 2,2'-Methylen-bis-(6-nonyl-4-methylphenol), 2,2'-Methylen-bis-(4,6-di-t-butylphenol), 2,2'-Ethyliden-bis-(4,6-di-t-butylphenol, 2,2'-Ethyliden-bis-(6-t-butyl-4-isobutylphenol), 2,2'-Methylen-bis-[6-($\alpha$-methylbenzyl)-4-nonylphenol], 2,2'-Methylen-bis-[6-($\alpha$,$\alpha$-dimethylbenzyl)-4-nonylphenol], 4,4'-Methylen-bis-(2,6-di-t-butylphenol), 4,4'-Methylen-bis-(6-t-butyl-2-methylphenol), 1,1-Bis-(5-t-butyl-4-hydroxy-2-methylphenyl)-butan, 2,6-Di-(3-t-butyl-5-methyl-2-hydroxybenzyl)-4-methylphenol, 1,1,3-Tris-(5-t-butyl-4-hydroxy-2-methylphenyl)-butan, 1,1-Bis-(5-t-butyl-4-hydroxy-2-methylphenyl)-3-n-dodecylmercaptobutan, Di-(3-t-butyl-4-hydroxy-5-methylphenyl)-dicyclo-pentadien, Di-[2-(3'-t-butyl-2'-hydroxy-5'-methyl-benzyl)-6-t-butyl-4-methyl-phenyl]-terephthalat;

5. Benzylverbindunge, beispielsweise 1,3,5-Tri-(3,5-di-t-butyl-4-hydroxybenzyl)-2,4,6-trimethylbenzol, Di-(3,5-di-t-butyl-4-hydroxybenzyl)-sulfid, 3,5-Di-t-butyl-4-hydroxybenzyl-mercaptoessigsäure-isooctylester, Bis-(4-t-butyl-3-hydroxy-2,6-dimethylbenzyl)-dithiol-terephthalat, 1,3,5-Tris-(3,5-di-t-butyl-4-hydroxybenzyl)-isocyanurat, 1,3,5-Tris-(4-t-butyl-3-hydroxy-2,6-dimethylbenzyl)-isocyanurat, 3,5-Di-t-butyl-4-hydroxybenzyl-phosphonsäure-dioctadecylester, Calciumsalz des 3,5-Di-t-butyl-4-hydroxybenzyl-phosphonsäure-mono-ethylesters;

6. Acylaminophenole, beispielsweise 4-Hydroxy-laurinsäureanilid, 4-Hydroxystearinsäureanilid, 2,4-Bis-octylmercapto-6-(3,5-di-t-butyl-4-hydroxy-anilino)-s-triazin, N-(3,5-Di-t-butyl-4-hydroxyphenyl)-carbaminsäure-octylester;

7. Ester der β-(3,5-Di-t-butyl-4-hydroxyphenyl)-propionsäure mit einwertigen Alkoholen, wie z.B. mit Methanol oder Octadecanol;

8. Ester der β-(5-t-Butyl-4-hydroxy-3-methylphenyl)-propionsäure mit einwertigen Alkoholen, wie z.B. mit Methanol oder Octadecanol;

9. Amide der β-(3,5-Di-t-butyl-4-hydroxyphenyl)-propionsäure, wie z.B. N,N'-Di-(3,5-di-t-butyl-4-hydroxyphenylpropionyl)-hexamethylendiamin, N,N'-Di-(3,5-di-t-butyl-4-hydroxyphenylpropionyl)-trimethylendiamin, N,N'-Di-(3,5-di-t-butyl-4-hydroxyphenylpropionyl)-hydrazin.

Die phenolischen Antioxidantien können auch in beliebiger Mischung untereinander eingesetzt werden.
Als bevorzugte Antioxidantien kommen in Frage: Hydrochinon, 4-Methoxyphenol, 2,4-Di-t-butylphenol und 2,6-Di-t-butylphenol.
Die Antioxidantien werden nach allgemein üblichen Methoden in die phosphormodifizierten Epoxidharze eingearbeitet, beispielsweise durch Einmischen. Sie können auch in Form eines Masterbatches zugesetzt werden. Die zur Stabilisierung benötigte Menge an Andioxydans beträgt im allgemeinen 0,005 bis 5 Gew.-%, bevorzugt 0,05 bis 2 Gew.-%, bezogen auf das Harz. Durch die Zumischung der Antioxidantien wird überraschenderweise die Lagerstabilität, beispielsweise bestimmt anhand der Viskositätszunahme einer entsprechenden Lösung, der phosphormodifizierten Epoxidharze, insbesondere bei höheren Temperaturen, deutlich erhöht. Da die Wirkung der phenolischen Antioxidantien darauf beruht, die Bildung von Radikalen zu hindern, war nicht zu erwarten gewesen, daß Epoxidharze durch Zusatz dieser Antioxidantien stabilisiert werden, da Epoxidharze auf ionische, aber nicht auf radikalische Einflüsse reagieren sollten.
Die erfindungsgemäß stabilisierten, phosphormodifizierten Epoxidharze lassen sich vorteilhaft als flammhemmende Additive (Reaktionsharze) in vielen Einsatzgebieten zur Herstellung von Formkörpern, Prepregs, Überzügen oder Laminaten (Verbundwerkstoffen) verwenden, insbesondere für Isolierzwecke in der Elektrotechnik. Dabei können diese phosphormodifizierten Epoxidharze auch in Abmischung mit phosphorfreien Epoxidharzen in Mengen bis zu 80 Gew.-%, vorzugsweise bis zu 50 Gew.-% eingesetzt werden. Als Härter können die bekannten Epoxidhärter, wie sie beispielsweise in der DE-Offenlegungsschrift 2 743 680 oder der EP-Offenlegungsschrift 274 646 beschrieben werden, Verwendung finden. Diese Materialien sind beispielsweise geeignet zum Abdecken, Beschichten und Umhüllen von elektronischen Bauelementen, zur Isolierung elektrischer Wicklungen, zur Herstellung von Isolierbauteilen und Verbundwerkstoffen mit faserförmigen Einlagerungskomponenten, insbesondere von Laminaten für die Leiterplattentechnik.

Beispiel

Die Viskosität kann als ein Maß für die Lagerstabilität betrachtet werden. Sie wird bestimmt nach Höppler und angegeben in mPa•s [25°C]. Eingesetzt wird ein mit Propanphosphonsäureanhydrid umgesetzter epoxierter Novolack mit einen Epoxidwert von 0,37 (mol/100 g) und einem Phosphorgehalt von 3,4 %. Daraus resultieren etwa 75 %ige Lösungen mit Methylethylketon und Ethylacetat. Je niedriger die Viskosität umso höher ist der Anteil der Lösungsmittel.

a) Bei einer Lösung mit einer Viskosität von 311 mPa•s [25°C] am Tage der Herstellung wird die Viskosität in Abhängigkeit von der Zeit gemessen, und zwar ohne sowie mit Zusatz von 0,3 % 4-Methoxyphenol bei Raumtemperatur.

| Viskosität mPa•s [25°C]: | ohne Zusatz | mit Zusatz | Zeitdauer [Monate] |
|---|---|---|---|
| | 311 | 311 | Start |
| | 370 | 347 | 3 |
| | 370 | 335 | 6 |
| | 413 | 362 | 9 |

b) Bei einer Lösung von 623 mPa•s [25°C] am Tage der Herstellung wird die Viskosität in Abhängigkeit von der Zeit gemessen, und zwar ohne sowie mit Zusatz von 0,3 % 4-Methoxyphenol bei Raumtemperatur.

| Viskosität mPa•s [25°C]: | ohne Zusatz | mit Zusatz | Zeitdauer [Monate] |
|---|---|---|---|
| | 623 | 623 | Start |
| | 670 | 638 | 1 |
| | 659 | 637 | 2 |
| | 694 | 640 | 4 |
| | 773 | 695 | 5 |

c) Bei einer Lösung von 707 mPa•s [25°C] am Tage der Herstellung wird die Viskosität in Abhängigkeit von der Zeit gemessen ohne und mit Zusatz von 0,3 % 2,4-Di-t-butylphenol bei 40°C.

| Viskosität mPa•s [25°C]: | ohne Zusatz | mit Zusatz | Zeitdauer [Monate] |
|---|---|---|---|
| | 707 | 707 | Start |
| | 765 | 719 | 1 |
| | 928 | 832 | 2 |
| | 905 | 826 | 4 |

Die Versuche zeigen eindeutig, daß die Viskositätserhöhung bei der Lagerung bei Raumtemperatur und 40°C ohne Zusatz der Antioxidantien deutlich höher liegt als bei Zusatz dieser Additive.

Der Epoxidwert wird durch die Bedingungen der Lagerung nicht verändert.

**Patentansprüche**

**1.** Phosphormodifiziertes Epoxidharz mit einem Epoxidwert von 0 bis 1 mol/100 g, enthaltend Struktureinheiten, die sich ableiten

(A) von Polyepoxidverbindungen mit mindestens zwei Epoxidgruppen pro Molekül
und
(B) von Phosphin- und/oder Phosphonsäureanhydriden,

dadurch gekennzeichnet, daß mindestens ein phenolisches Antioxidans beigemischt ist.

**2.** Phosphormodifiziertes Epoxidharz nach Anspruch 1, dadurch gekennzeichnet, daß die Menge an phenolischem Antioxidans 0,005 bis 5 Gew.-%, bezogen auf das Harz, beträgt.

**3.** Phosphormodifiziertes Epoxidharz nach Anspruch 1 oder 2, dadurch gekennzeichnet, daß als phenolisches Antioxidans Hydrochinon, 4-Methoxyphenol, 2,4-Di-t-butylphenol oder 2,6-Di-t-butylphenol oder entsprechende Gemische eingesetzt werden.

**4.** Phosphormodifiziertes Epoxidharz nach einem oder mehreren der Ansprüche 1 bis 3, dadurch gekennzeichnet, daß der Phosphorgehalt 0,5 bis 13 Gew.-%, bezogen auf das Harz, beträgt.

**5.** Phosphormodifiziertes Epoxidharz nach einem oder mehreren der Ansprüche 1 bis 4, dadurch gekennzeichnet, daß der Epoxidwert zwischen 0,02 und 1 mol/100 g liegt.

**6.** Phosphormodifiziertes Epoxidharz nach einem oder mehreren der Ansprüche 1 bis 5, dadurch gekennzeichnet, daß es im Mittel mindestens eine Epoxidgruppe pro Molekül enthält.

**7.** Phosphormodifiziertes Epoxidharz nach einem oder mehreren der Ansprüche 1 bis 6, dadurch gekennzeichnet, daß das mittlere Molekulargewicht $\overline{M}_n$ des Harzes Werte zwischen 200 und 5000 besitzt.

**8.** Phosphormodifiziertes Epoxidharz nach einem oder mehreren der Ansprüche 1 bis 7, dadurch gekennzeichnet,

daß das mittlere Molekulargewicht $\overline{M}_n$ der Bausteine (A) 150 bis 4000 beträgt.

**9.** Phosphormodifiziertes Epoxidharz nach einem oder mehreren der Ansprüche 1 bis 8, dadurch gekennzeichnet, daß sich der Baustein (A) von Polyepoxidverbindungen mit 2 bis 6 Epoxidgruppen pro Molekül ableitet.

**10.** Phosphormodifiziertes Epoxidharz nach einem oder mehreren der Ansprüche 1 bis 9, dadurch gekennzeichnet, daß sich der Baustein (A) von Polyglycidylethern auf Basis von mehrwertigen Phenolen, Hydrierungsprodukten dieser Phenole und/oder von Novolaken ableitet.

**11.** Phosphormodifiziertes Epoxidharz nach einem oder mehreren der Ansprüche 1 bis 10, dadurch gekennzeichnet, daß sich die Struktureinheiten (B) von Phosphinsäureanhydriden der Formeln (I) und/oder (II) ableiten

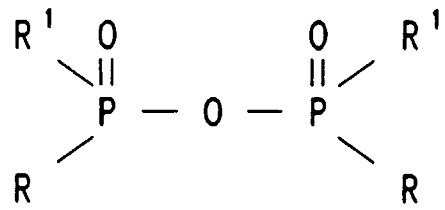

(I)

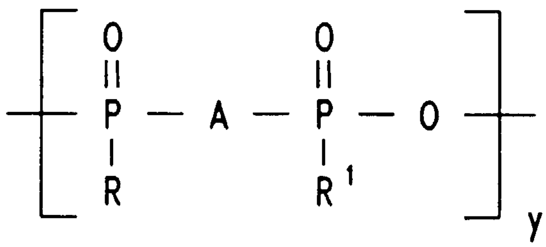

(II)

in denen bedeuten

R und $R^1$ unabhängig voneinander einen Kohlenwasserstoffrest von 1 bis 20 C-Atomen, vorzugsweise 1 bis 6 C-Atomen,
A einen zweiwertigen Kohlenwasserstoffrest mit 1 bis 10 C-Atomen, vorzugsweise 1 bis 6 C-Atomen und
y eine ganze Zahl von mindestens 1, vorzugsweise 1 bis 100.

**12.** Phosphormodifiziertes Epoxidharz nach Anspruch 11, dadurch gekennzeichnet, daß sich die Struktureinheiten (B) alternativ oder zusätzlich von Phosphonsäureanhydriden der Formel (III) ableiten

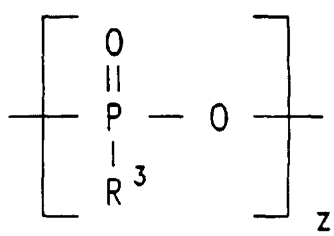

(III)

in der $R^3$ die gleiche Bedeutung wie $R/R^1$ gemäß den Formeln (I) bzw. (II) besitzt und z für mindestens 3, vorzugsweise 3 bis 100 steht.

**13.** Phosphormodifiziertes Epoxidharz nach einem oder mehreren der Ansprüche 1 bis 12, dadurch gekennzeichnet, daß es im wesentlichen die Formeln (IV), (V) und/oder (VI) besitzt

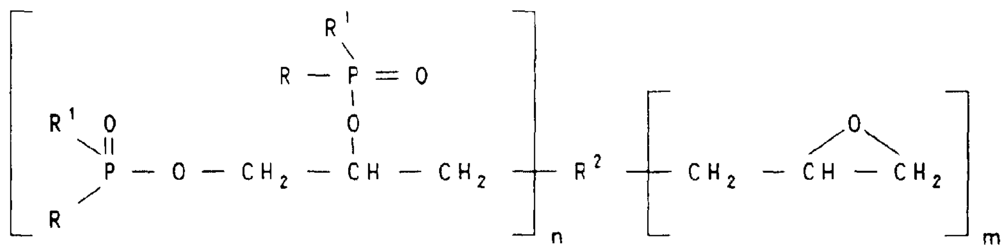

(IV)

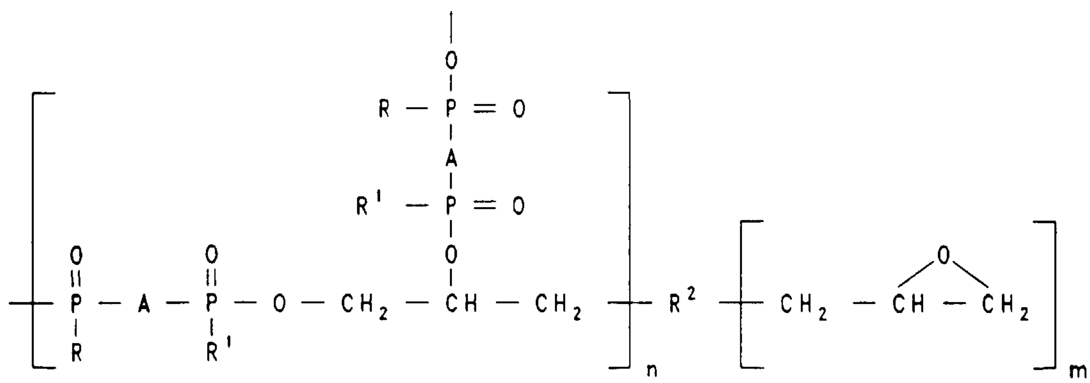

(V)

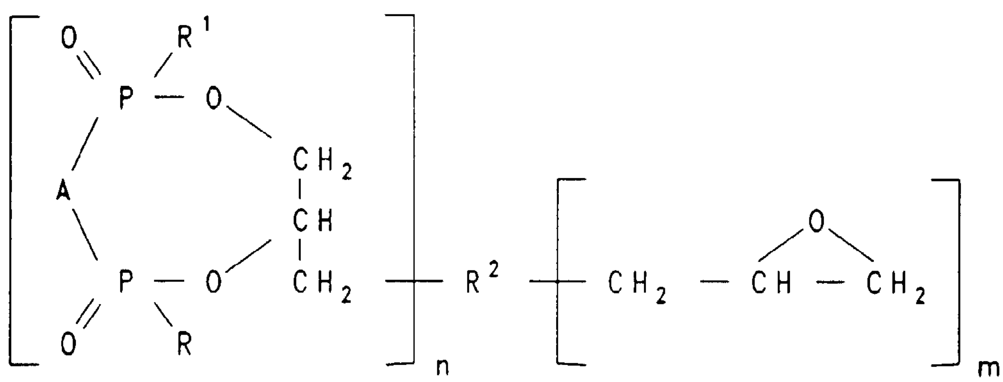

(Va)

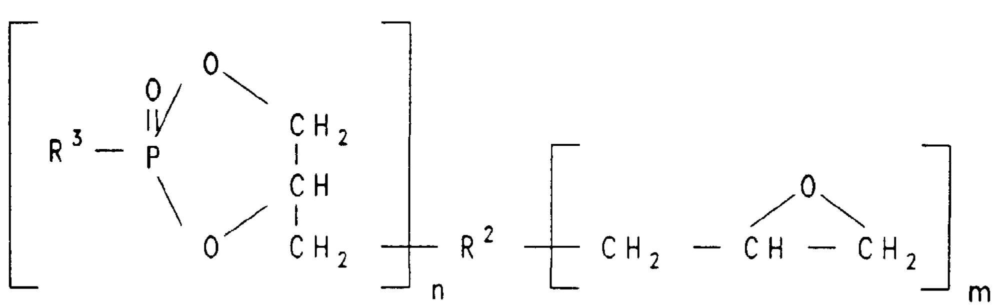

(VI)

in denen bedeuten

R, $R^1$ und $R^3$ gleiche Bedeutung wie unter den obigen Formeln (I) bis (III);
$R^2$ den um die Glycidylgruppen verminderten Rest einer Polyepoxidverbindung;
n = ganze Zahlen von 1 bis 5;

m = ganze Zahlen von 1 bis 5, wobei die Summe n+m eine ganze Zahl von 2 bis 6 sein soll.

**14.** Phosphormodifiziertes Epoxidharz nach Anspruch 13, dadurch gekennzeichnet, daß es im wesentlichen nur die Formel (VI) besitzt.

**15.** Verwendung des phosphormodifizierten Epoxidharzes nach einem oder mehreren der Ansprüche 1 bis 14 zur Herstellung von Formkörpern, Überzügen oder Laminaten, vorzugsweise für die Elektrotechnik.

**16.** Formkörper, Überzüge oder Laminate, hergestellt unter Verwendung des phosphormodifizierten Epoxidharzes gemäß einem oder mehreren der Ansprüche 1 bis 14.

## Claims

**1.** A phosphorus-modified epoxy resin having an epoxide value of 0 to 1 mol/100 g containing structural units which are derived from

(A) polyepoxide compounds having at least two epoxide groups per molecule and
(B) phosphinic and/or phosphonic acid anhydrides,

wherein at least one phenolic antioxidant is admixed.

**2.** A phosphorus-modified epoxy resin as claimed in claim 1, wherein the amount of phenolic antioxidant is 0.005 to 5% by weight, based on the resin.

**3.** A phosphorus-modified epoxy resin as claimed in claim 1 or 2, wherein the phenolic antioxidant employed is hydroquinone, 4-methoxyphenol, 2,4-di-t-butylphenol or 2,6-di-t-butylphenol or a corresponding mixture.

**4.** A phosphorus-modified epoxy resin as claimed in one or more of claims 1 to 3, wherein the phosphorus content is 0.5 to 13% by weight, based on the resin.

**5.** A phosphorus-modified epoxy resin as, claimed in one or more of claims 1 to 4, wherein the epoxide value is between 0.02 and 1 mol/100 g.

**6.** A phosphorus-modified epoxy resin as claimed in one or more of claims 1 to 5, which contains on average at least one epoxide group per molecule.

**7.** A phosphorus-modified epoxy resin as claimed in one or more of claims 1 to 6, wherein the average molecular weight $\overline{M}_n$ of the resin has values between 200 and 5000.

**8.** A phosphorus-modified epoxy resin as claimed in one or more of claims 1 to 7, wherein the average molecular weight $\overline{M}_n$ of the structural units (A) is 150 to 4000.

**9.** A phosphorus-modified epoxy resin as claimed in one or more of claims 1 to 8, wherein the structural unit (A) is derived from polyepoxide compounds having 2 to 6 epoxide groups per molecule.

**10.** A phosphorus-modified epoxy resin as claimed in one or more of claims 1 to 9, wherein the structural unit (A) is derived from polyglycidyl ethers based on polyhydric phenols, hydrogenation products of these phenols and/or on novolaks.

**11.** A phosphorus-modified epoxy resin as claimed in one or more of claims 1 to 10, wherein the structural units (B) are derived from phosphinic acid anhydrides of the formulae (I) and/or (II)

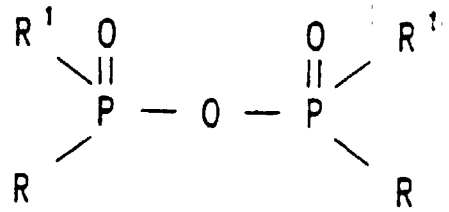

(I)

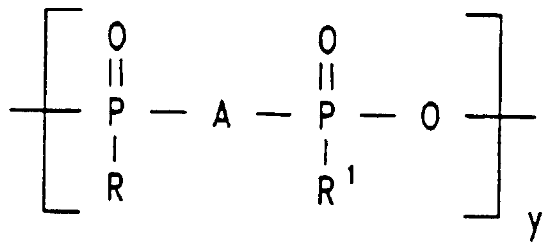

(II)

in which

R and $R^1$ independently of one another are a hydrocarbon radical having 1 to 20 carbon atoms, preferably 1 to 6 carbon atoms,
A is a divalent hydrocarbon radical having 1 to 10 carbon atoms, preferably 1 to 6 carbon atoms, and y is an integer of at least 1, preferably 1 to 100.

**12.** A phosphorus-modified epoxy resin as claimed in claim 11, wherein the structural units (B) alternatively or additionally are derived from phosphonic acid anhydrides of the formula (III)

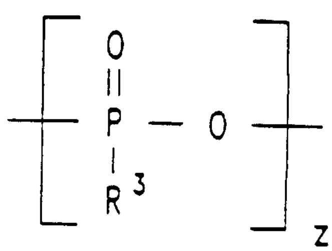

(III)

in which $R^3$ has the same meaning as $R/R^1$ according to the formulae (I) and (II) and z is at least 3, preferably 3 to 100.

**13.** A phosphorus-modified epoxy resin as claimed in one or more of claims 1 to 12, which essentially has the formulae (IV), (V) and/or (VI)

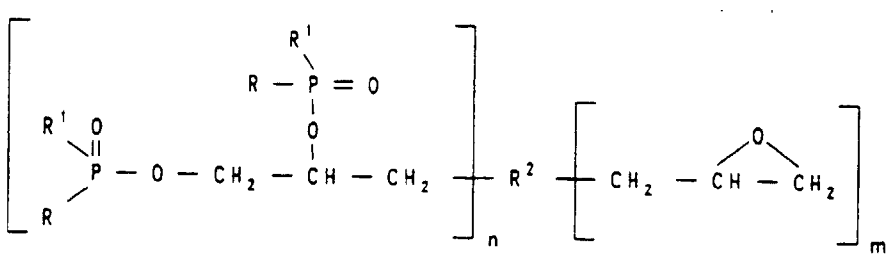

(IV)

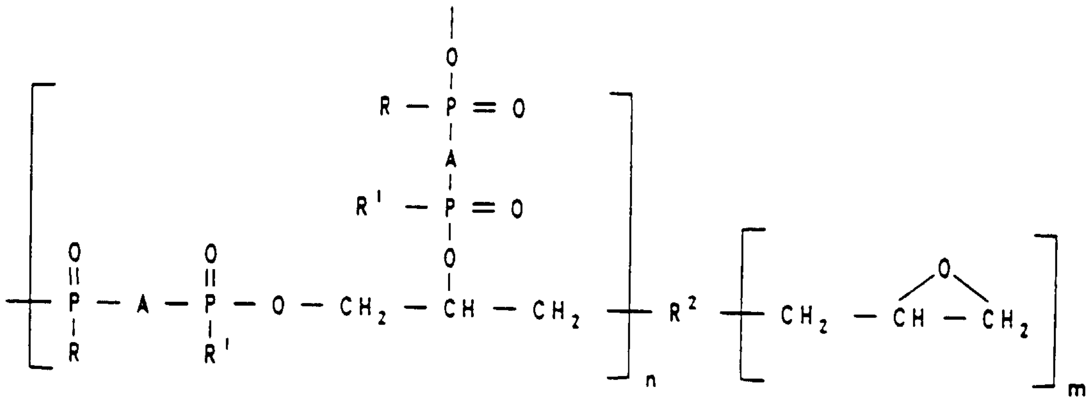

(V)

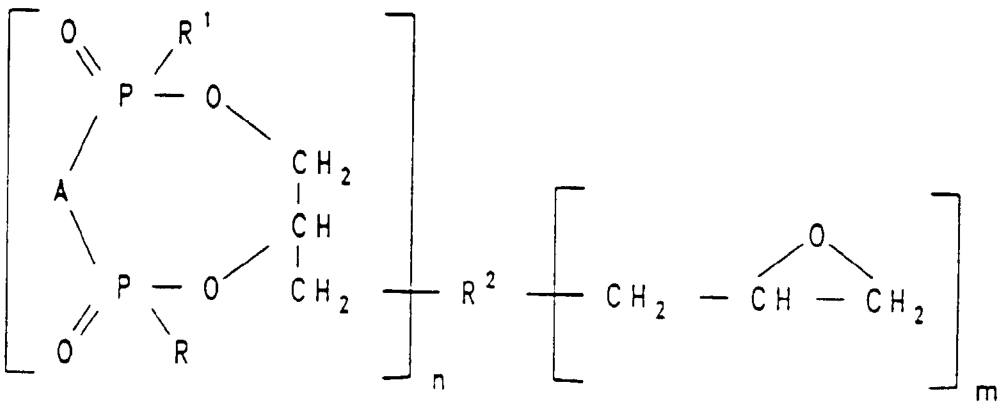

(Va)

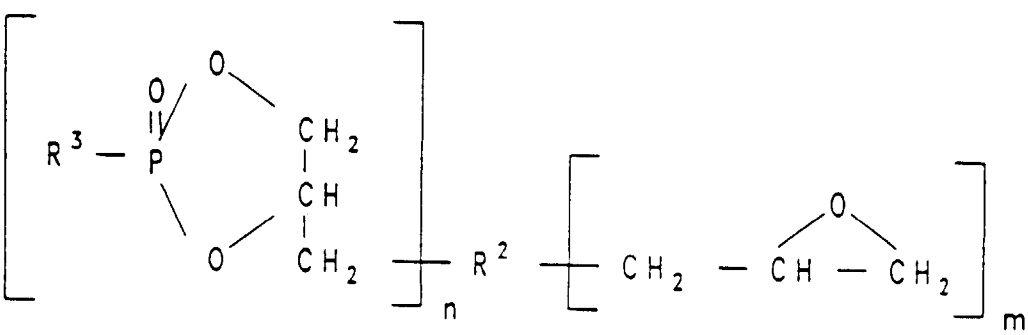

(VI)

in which

R, $R^1$ and $R^3$ have the same meaning as under the above formulae (I) to (III);
$R^2$ is the radical of a polyepoxide compound reduced by the glycidyl groups;
n = integers from 1 to 5;
m = integers from 1 to 5, and wherein the sum n+m should be an integer from 2 to 6.

**14.** A phosphorus-modified epoxy resin as claimed in claim 13, which essentially has only the formula (VI).

**15.** The use of a phosphorus-modified epoxy resin as claimed in one or more of claims 1 to 14 for the production of shaped articles, coatings or laminates, preferably for electrical engineering.

**16.** A shaped article, coating or laminate produced using a phosphorus-modified epoxy resin as claimed in one or

more of claims 1 to 14.

**Revendications**

1. Résine époxyde modifiée par du phosphore avec un indice d'époxyde de 0 à 1 mol/100 g, contenant des motifs de structure, qui dérivent

   (A) de composés polyépoxydes avec au moins deux groupes époxyde par molécule et
   (B) d'anhydrides d'acide phosphinique et/ou phosphonique,

   caractérisée en ce qu'on leur adjoint par mélange au moins un antioxydant phénolique.

2. Résine époxyde modifiée par du phosphore selon la revendication 1, caractérisée en ce que la quantité d'antioxydant phénolique se monte à 0,005 à 5% en poids, par rapport à la résine.

3. Résine époxyde modifiée par du phosphore selon la revendication 1 ou 2, caractérisée en ce qu'on utilise comme antioxydant phénolique l'hydroquinone, le 4-méthoxyphénol, le 2,4-di-tert.-butylphénol ou le 2,6-di-tert.-butylphénol ou des mélanges correspondants.

4. Résine époxyde modifiée par du phosphore selon une ou plusieurs des revendications 1 à 3, caractérisée en ce que le titre en phosphore s'élève à 0,5 à 13% en poids, par rapport à la résine.

5. Résine époxyde modifiée par du phosphore selon une ou plusieurs des revendications 1 à 4, caractérisée en ce que l'indice d'époxyde se situe entre 0, 02 et 1 mol/100 g.

6. Résine époxyde modifiée par du phosphore selon une ou plusieurs des revendications 1 à 5, caractérisée en ce qu'elle contient en moyenne au moins un groupe époxyde par molécule.

7. Résine époxyde modifiée par du phosphore selon une ou plusieurs des revendications 1 à 6, caractérisée en ce que la masse moléculaire moyenne $\overline{M}_n$ de la résine possède des valeurs entre 200 et 5000.

8. Résine époxyde modifiée par du phosphore selon une ou plusieurs des revendications 1 à 7, caractérisée en ce que la masse moléculaire moyenne $\overline{M}_n$ des composants (A) s'élève à 150 à 4000.

9. Résine époxyde modifiée par du phosphore selon une ou plusieurs des revendications 1 à 8, caractérisée en ce que le composant (A) dérive de composés polyépoxyde ayant 2 à 6 groupes époxyde par molécule.

10. Résine époxyde modifiée par du phosphore selon une ou plusieurs des revendications 1 à 9, caractérisée en ce que le composant (A) dérive d'éthers de polyglycidyle à base de phénols polyhydroxylés, de produits d'hydrogénation de ces phénols et/ou de novolaques.

11. Résine époxyde modifiée par du phosphore selon une ou plusieurs des revendications 1 à 10, caractérisée en ce que les motifs de structure (B) dérivent d'anhydrides d'acide phosphinique de formules (I) et/ou (II)

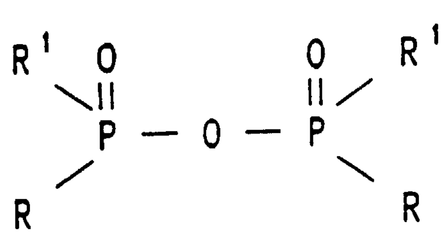

(I)

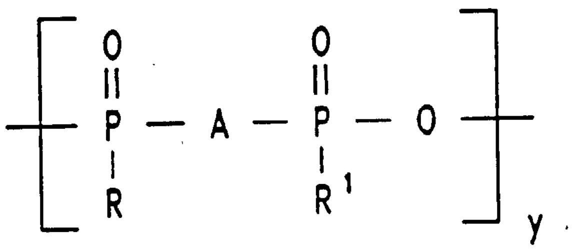

(II)

dans lesquelles

R et $R^1$ représentent indépendamment l'un de l'autre un groupe hydrocarboné de 1 à 20 atomes de carbone, de préférence de 1 à 6 atomes de carbone,

A représente un groupe hydrocarboné divalent ayant 1 à 10 atomes de carbone, de préférence 1 à 6 atomes de carbone et

y représente un nombre entier d'au moins 1, de préférence de 1 à 100.

**12.** Résine époxyde modifiée par du phosphore selon la revendication 11, caractérisée en ce que les motifs de structure (B) dérivent en tant qu'alternative ou de manière additionnelle d'anhydrides d'acide phosphonique de formule (III)

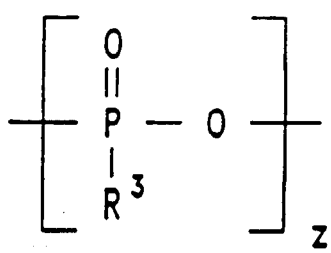

(III)

dans laquelle $R^3$ possède la même signification que $R/R^1$ selon la formule (I) ou (II) et z représente au moins 3, de préférence de 3 à 100.

**13.** Résine époxyde modifiée par du phosphore selon une ou plusieurs des revendications 1 à 12, caractérisée en ce qu'elle possède essentiellement les formules (IV), (V) et/ou (VI)

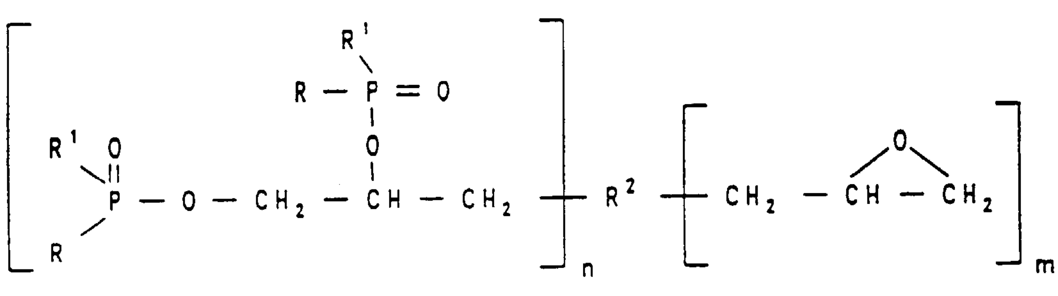

(IV)

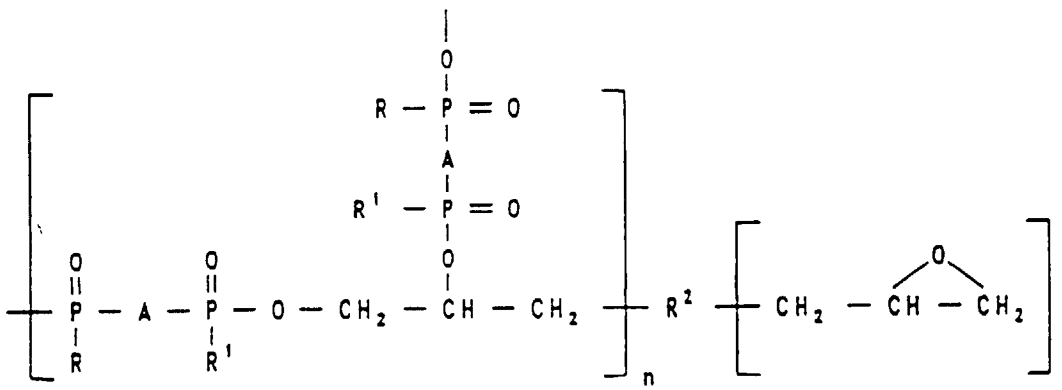

(V)

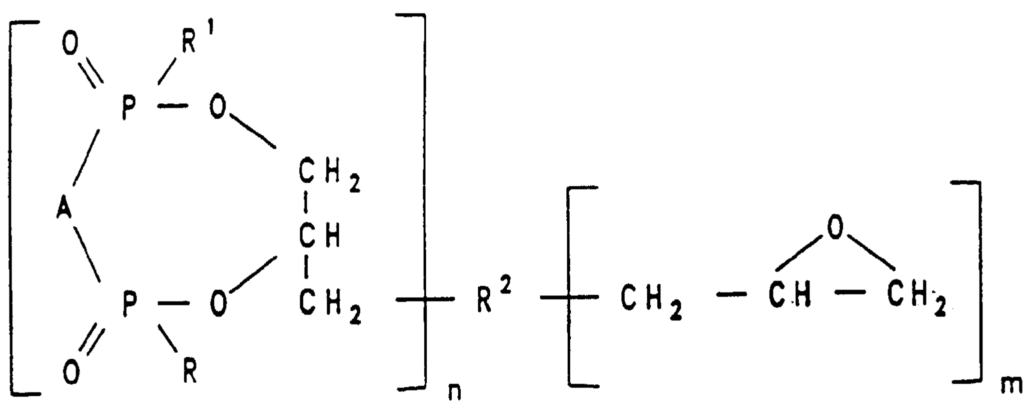

(Va)

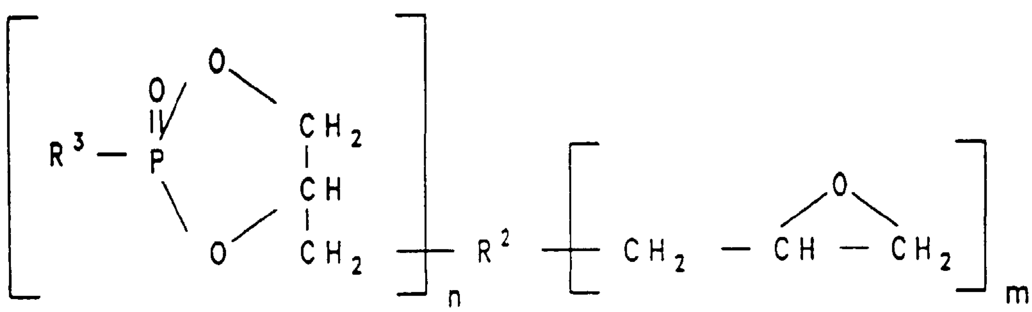

(VI)

formules dans lesquelles

R, $R^1$ et $R^3$ ont la même signification que dans les formules ci-dessus mentionnées (I) à (III);
$R^2$ représente le résidu d'un composé polyépoxyde diminué des groupes glycidyle;
n = des nombres entiers de 1 à 5;
m = des nombres entiers de 1 à 5, la somme n + m devant être un nombre entier de 2 à 6.

**14.** Résine époxyde modifiée par du phosphore selon la revendication 13, caractérisée en ce qu'elle possède essentiellement seulement la formule (VI).

**15.** Utilisation de la résine époxyde modifiée par du phosphore selon une ou plusieurs des revendications 1 à 14 pour la fabrication de pièces formées, de revêtements ou de stratifiés, de préférence pour l'électrotechnique.

**16.** Pièces formées, revêtements ou stratifiés, fabriqués en utilisant la résine époxyde modifiée par du phosphore selon une ou plusieurs des revendications 1 à 14.